Europäisches Patentamt

European Patent Office

Office européen des brevets

(19)

(11) Numéro de publication: **0 063 061
B1**

# (12) FASCICULE DE BREVET EUROPEEN

(45) Date de publication du fascicule du brevet:
**22.08.84**

(21) Numéro de dépôt: **82400462.6**

(22) Date de dépôt: **12.03.82**

(51) Int. Cl.³: **H 04 N 9/04,** H 04 N 3/15,
H 01 L 27/14

(54) **Dispositif d'analyse d'images en couleur utilisant le transfert de charges électriques, et caméra de télévision comportant un tel dispositif.**

(30) Priorité: **31.03.81 FR 8106432**

(43) Date de publication de la demande:
**20.10.82 Bulletin 82/42**

(45) Mention de la délivrance du brevet:
**22.08.84 Bulletin 84/34**

(84) Etats contractants désignés:
**DE FR GB NL**

(56) Documents cités:
**EP - A - 0 038 725
FR - A - 2 314 584
FR - A - 2 367 353
FR - A - 2 376 517
GB - A - 2 001 504
US - A - 4 016 550
US - A - 4 047 203**

(73) Titulaire: **THOMSON-CSF, 173, Boulevard Haussmann,
F-75379 Paris Cedex 08 (FR)**

(72) Inventeur: **Berger, Jean-Luc, THOMSON-CSF
SCPI 173, bld Haussmann, F-75360 Paris Cedex 08 (FR)**
Inventeur: **Descure, Pierrick, THOMSON-CSF
SCPI 173, bld Haussmann, F-75360 Paris Cedex 08 (FR)**

(74) Mandataire: **Mayeux, Michèle et al, THOMSON-CSF
SCPI 173, Bld Haussmann, F-75379 Paris Cedex 08 (FR)**

ACTORUM AG

## Description

La présente invention se rapporte au domaine de l'analyse électrique d'images lumineuses utilisant le transfert de charges dans un semi-conducteur; elle a pour objet un dispositif plus particulièrement adapté à l'analyse d'images en couleurs.

On connaît différents dispositifs à l'état solide pour l'analyse d'une image lumineuse, qui sont destinés à être utilisés dans une caméra de télévision pour fournir un signal électrique vidéo. Ils se distinguent par le mode de réalisation de la zone photosensible, d'une part, et le système de lecture et d'évacuation des charges créées par l'image, d'autre part.

Il est également connu d'utiliser des dispositifs à transfert de charges pour réaliser ces différentes fonctions, comme il est décrit par exemple dans l'ouvrage de Sequin et Tompsett, intitulé «Charge transfer devices» (pp. 152 à 169):

— dans des organisations dites à transfert de trame ou à structure interligne, dans lesquelles le rayonnement lumineux est reçu sur des registres à transfert de charges; dans ces dispositifs, le transfert de charges est réalisé sur de grandes surfaces, ce qui constitue un inconvénient du fait qu'il est actuellement difficile d'obtenir des rendements élevés pour la fabrication de ces grandes surfaces;

— dans des dispositifs dits CID (Charge Injection Devices) qui ne présentent pas cet inconvénient, mais qui nécessitent en général une réinjection des charges dans le substrat semi-conducteur, ce qui présente un certain nombre d'inconvéneints, parmi lesquels du bruit ou des difficultés au niveau des valeurs des capacités nécessaires pendant ou après la lecture des charges.

Par le document US-A Nº 4047203, on connaît un dispositif d'analyse d'images en couleurs utilisant le transfert de charges électriques, comportant un ensemble photosensible formé par une pluralité de zones photosensibles élémentaires ou points, dans lesquelles sont créées des charges électriques en fonction de l'éclairement reçu, réalisées sur un même substrat semi-conducteur selon N lignes et M colonnes formant une matrice, chaque point recevant un filtre coloré destiné à ne le rendre sensible qu'à une couleur prédéfinie. L'information contenue dans chaque ligne de la matrice est décalée d'une ligne à l'autre, puis dans le registre de lecture.

Plus généralement, en sus des problèmes évoqués ci-dessus, se pose la question de la compatibilité des temps nécessaires, d'une part, à l'intégration lumineuse et, d'autre part, au transfert des charges dans le cas où cette solution est retenue, avec les temps de balayage de l'écran de télévision qui sont, selon le standard 625 lignes habituel, environ de 52 µs pour le temps d'affichage d'une ligne et de 12 µs pour le temps de retour ligne.

Pour répondre à ces différents impératifs, la titulaire a proposé une structure dite à transfert de ligne, décrite dans la demande européenne EP-A Nº 0038725 publiée le 28 octobre 1981, qui comporte principalement:

— une matrice de N lignes × M zones, ou points photosensibles, matrice sur laquelle une image à lire est projetée et convertie en charges électriques;

— une mémoire de M points, dite mémoire de ligne, destinée à recevoir successivement les charges signal stockées par chaque ligne;

— un registre à décalage du type CCD (Charge Coupled Devices), recevant en parallèle le contenu de la mémoire de ligne et délivrant en série le signal électrique d'analyse de l'image.

La présente invention a pour objet des perfectionnements à la structure du dispositif à transfert de ligne décrit ci-dessus, visant à l'adapter à l'analyse d'images en couleurs.

A cet effet, le dispositif d'analyse d'images en couleurs, utilisant le transfert de charges électriques, selon l'invention, comporte un ensemble photosensible formé d'une pluralité de zones photosensibles élémentaires, appelées points, dans lesquelles sont créées des charges électriques en fonction de l'éclairement reçu, réalisées sur un même substrat semi-conducteur selon N lignes et M colonnes et isolées les unes des autres, formant une matrice, chaque point recevant un filtre coloré destiné à ne le rendre sensible qu'à uine couleur prédéfinie, et est est caractérisé en ce que:

— chacune de ces zones élémentaires comporte une capacité MOS, constituant une première zone de collection de charges et comportant une grille qui est commune aux capacités d'une même ligne, et une seconde zone de collection de charges, électriquement couplée à la capacité;

— des moyens de connexion et de commande assurent la fourniture en parallèle, par l'intermédiaire de connexions de colonne, des charges électriques créées dans les M points d'une même ligne, successivement pour les N lignes, ces moyens comportant une pluralité de diodes de lecture, arrangées en colonnes entre les points de façon à recevoir chacune, successivement, sur commande, les charges d'au moins deux points appartenant à deux lignes différentes;

— des moyens formant écran pour les charges sont placés entre chacun des points et les moyens de connexion, ces moyens-écrans comportant une pluralité de grilles arrangées en colonnes entre les diodes de lecture et les points et portées à un potentiel constant au moins lors du transfert des charges des points vers les moyens de connexion;

— deux mémoires, dites mémoires de ligne, réalisées dans le même substrat semi-conducteur, reçoivent en parallèle les charges électriques fournies par les moyens de connexion et de commande de telle sorte que chaque point de la matrice soit affecté à l'une seulement des deux mémoires de ligne, l'une de ces mémoires n'étant reliée qu'aux points d'une même couleur;

— deux registres à décalage analogiques reçoivent en parallèle respectivement les charges fournies par les deux mémoires de ligne et délivrent en série chacun un signal électrique d'analyse de l'image.

L'invention a également pour objet une caméra de télévision comportant un tel dispositif d'analyse d'images.

L'invention est décrite, à titre d'exemple non limitatif, plus en détail dans ce qui suit à l'aide des figures annexées, qui représentent:

la fig. 1, l'organisation générale d'une structure à transfert de ligne;

la fig. 2, un premier mode de réalisation du dispositif selon l'invention;

la fig. 3a, une vue de dessus, et la figb. 3b, une vue en coupe d'une matrice de points photosensibles susceptible d'être utilisée dans le dispositif de la fig. 2;

la fig. 4a, un deuxième mode de réalisation du dispositif selon l'invention, et la fig. 4b, des diagrammes de signaux relatifs à la fig. 4a;

la fig. 5a, une vue de dessus, et la fig. 5b, une vue en coupe d'un mode de réalisation d'une matrice de points photosensibles utilisable dans le dispositif de la fig. 4a;

la fig. 6a, une variante de réalisation de la fig. 4, et la fig. 6b, des diagrammes de signaux relatifs à la fig. 6a;

la fig. 7a, une vue de dessus, et la fig. 7b, une vue en coupe d'un mode de réalisation d'une matrice de points photosensibles susceptible d'être utilisée dans le dispositif de la fig. 6a.

Sur ces différentes figures, les mêmes références se rapportent aux mêmes éléments.

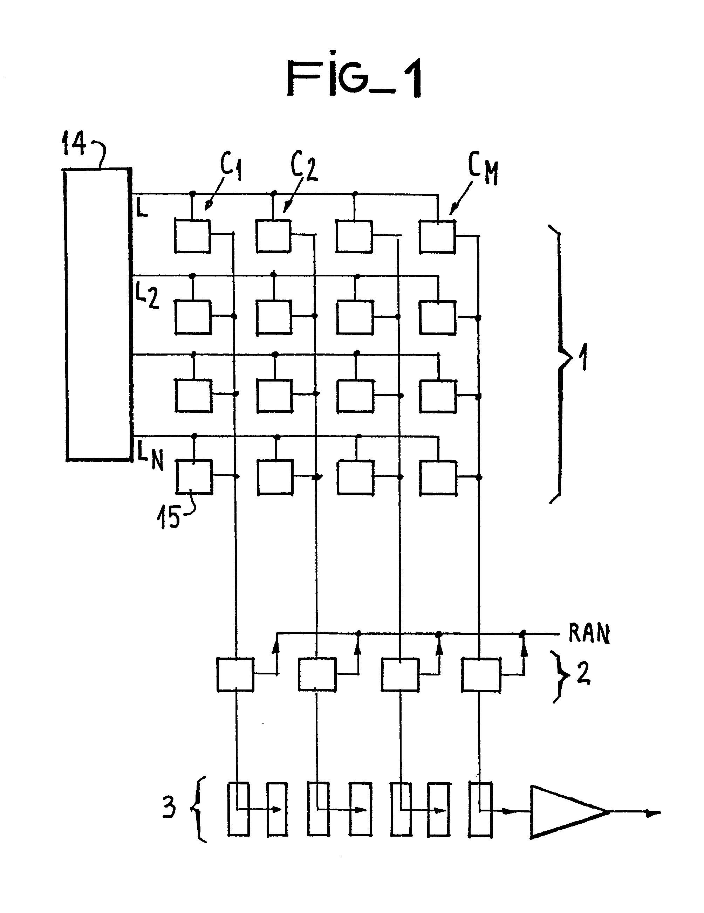

La fig. 1 représente donc l'organisation générale d'une structure à transfert de lignes, telle que décrite dans la demande européenne précitée.

Cette structure comporte principalement une zone photosensible 1, une mémoire de ligne 2 et un registre à décalage 3 analogique de sortie.

La zone photosensible 1 reçoit l'image lumineuse à analyser et la transforme en charges électriques. Il est à noter qu'on vise ici, par image lumineuse, la détection non seulement des longueurs d'onde visibles, mais également de celles qui les entourent, notamment dans l'infrarouge. La zone photosensible est constituée par une pluralité de zones élémentaires 15, également appelées ci-dessous points, arrangées en N lignes, repérées $L_1, L_2 ... L_N$, et M colonnes, repérées $C_1, C_2 ... C_M$, et formant une matrice. Les points photosensibles d'une même ligne sont reliés entre eux et reliés à un dispositif de commande 14, permettant d'adresser les lignes les unes après les autres; ce dispositif est constitué par exemple par un registre à décalage du type MOS. Les points photosensibles 15 d'une même colonne sont reliés à une même connexion, dite ci-après connexion de colonne, vers la mémoire de ligne 2.

La mémoire de ligne 2 reçoit donc en parallèle les charges créées dans chacun des points photosensibles 15 d'une même ligne, puis elle les transfère également en parallèle vers le registre 3, qui est un registre à décalage analogique, du type CCD, et qui fournit donc l'information, reçue en parallèle, en mode série; cette information constitue le signal vidéo d'analyse de l'image optique reçue sur la zone photosensible 1.

L'enchaînement des différentes opérations d'intégration de l'image au niveau de la zone photosensible 1, du transfert des lignes dans la mémoire de ligne 2, puis du transfert des signaux dans le registre 3, pour les différentes lignes, est maintenant décrit.

Tout d'abord, il est à noter que l'intégration de l'image est réalisée en permanence sur la totalité de la matrice photosensible 1, sauf sur celle des lignes qui est adressée par le registre 14.

Pendant le temps de retour ligne, le contenu de la mémoire de ligne 2 est transféré dans le registre à décalage 3, l'entrée de la mémoire de ligne étant alors fermée.

Pendant le temps ligne qui suit, le contenu du registre 3 est évacué en série, la connexion entre la mémoire de ligne 2 et le registre 3 est interrompue. Pendant ce temps, il se produit, dans une première phase, une remise à niveau des moyens de lecture des points 15, par l'intermédiaire de la connexion repérée RAN sur la fig. 1, reliée à la mémoire de ligne 2 et, dans une deuxième phase, on opère le transfert de l'une des lignes L de la zone 1 vers la mémoire de ligne 2, la sélection (ou adressage) d'une ligne étant assurée par le registre 14.

L'étape suivante correspond au temps de retour ligne pendant lequel s'opère le déversement du contenu de la mémoire de ligne 2 dans le registre 3, celui-ci ayant été entièrement lu lors de l'étape précédente.

Dans un autre mode de réalisation, la sélection d'une ligne, son transfert dans la mémoire de ligne puis dans le registre à décalage s'effectuent entièrement pendant le temps de retour ligne, le temps de ligne étant réservé à la remise à niveau des moyens de lecture, qui est d'autant meilleure qu'elle est plus longue, et à l'évacuation en série du registre à décalage.

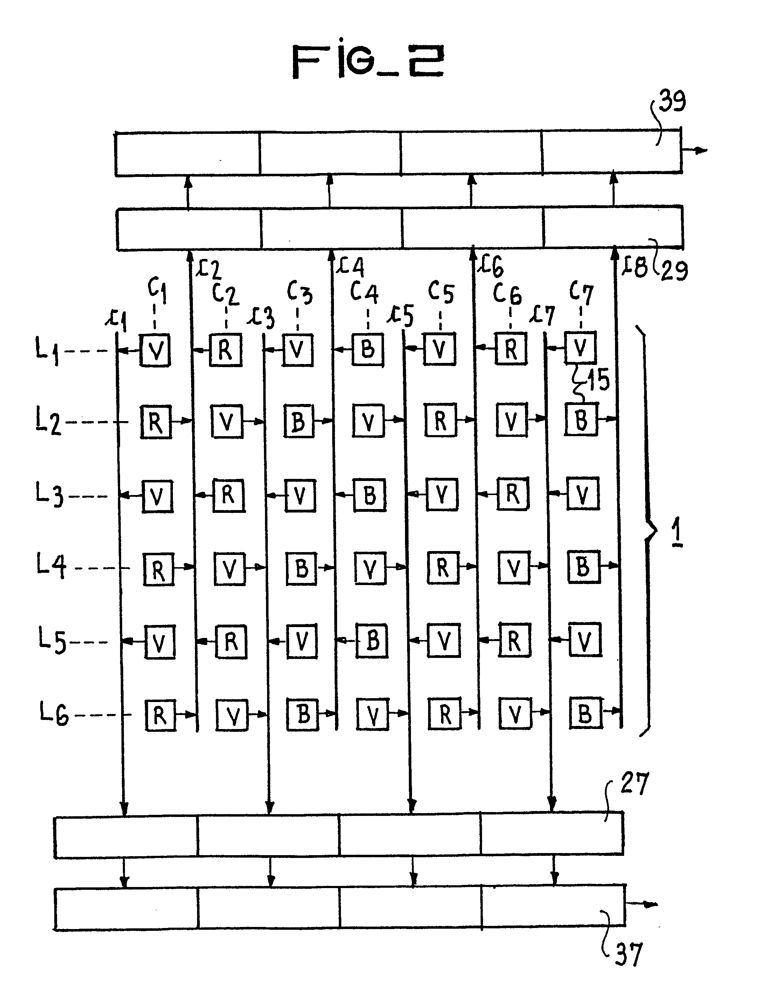

La fig. 2 représente un premier mode de réalisation du dispositif selon l'invention.

Sur cette figure, on a schématisé la matrice photosensible 1 par ses zones élémentaires, ou points, 15, arrangées en lignes L (par exemple, six lignes $L_1$ à $L_6$ sur la figure) et en colonnes C (par exemple, sept colonnes $C_1$ à $C_7$). Chacun des points photosensibles est, ainsi qu'il est connu pour réaliser une prise de vues en couleurs, recouvert d'un filtre coloré de telle sorte qu'il ne laisse passer que l'une de trois couleurs, par exemple vert, rouge ou bleu; sur la figure, les points photosensibles 15 sont repérés R, V ou B selon qu'ils détectent le rouge, le vert ou le bleu. Les filtres sont répartis selon un arrangement en quinconce interligne dans lequel les points V, sensibles au vert, appelés plus simplement points verts, sont les plus nombreux du fait que, ainsi qu'il est connu, ce sont ceux qui donnent un maximum de sensibilité et donc qui sont principalement uitlisés pour obtenir un signal de luminance; de plus, le quinconce permet, ainsi qu'il est également connu, d'augmenter la résolution apparente. Cet arrangement consiste donc à avoir un point vert tous les deux points photosensibles de chaque ligne, et de disposer ces points verts en quinconce d'une ligne à l'autre; sur chaque ligne, les points photosensibles restants sont alternativement verts ou bleus: on obtient ainsi la répétition de la séquence vert-rouge-vert-bleu.

La mémoire de ligne 2 de la fig. 1 est ici décomposée en deux mémoires, respectivement 27 et 29, situées de part et d'autre de la matrice photosensible 1. L'une de ces mémoires de ligne (27) est reliée aux connexions de colonne de rang impair (notées $c_1$, $c_3$, $c_5$ et $c_7$ sur la figure), alors que l'autre mémorie de ligne (29) est reliée aux connexions de colonne de rang pair ($c_2$, $c_4$, $c_6$ et $c_8$). Tous les points photosensibles des lignes impaires ($L_1$, $L_3$, $L_5$) sont reliées à une connexion de colonne qui se trouve à leur gauche, tous les points photosensibles d'une ligne paire ($L_2$, $L_4$, $L_6$) sont reliés à la connexion de colonne qui se trouve à leur droite, avec une ligne $L_1$ commençant par un point vert, la colonne $c_1$ étant située à sa gauche. On constate ainsi que tous les points verts sont reliés aux connexions de colonne de rang impair et donc à une même mémoire de ligne (27), les autres points photosensibles étant disposés de telle sorte que les connexions de colonne paires fournissent les unes la couleur rouge (colonnes $c_2$ et $c_6$) et les autres la couleur bleue ($c_4$ et $c_8$).

A chacune des mémoirse de ligne 27 et 29 est relié en parallèle un registre de sortie, respectivement 37 et 39, ces registres étant analogues au registre 3 de la fig. 1. De la sorte, le registre 37 qui est relié à la mémoire 27 fournit un signal électrique représentant la seule couleur verte, ce qui permet d'en déduire le signal de luminance; le registre 39 fournit alternativement le signal de chrominance bleu puis le signal de chrominance rouge, qui peuvent être ainsi aisément séparés en aval du dispositif d'analyse.

Cette structure, en réalisant la lecture des charges dans deux directions différentes, permet donc de faciliter l'élaboration du signal de luminance et la séparation des composantes de la chrominance.

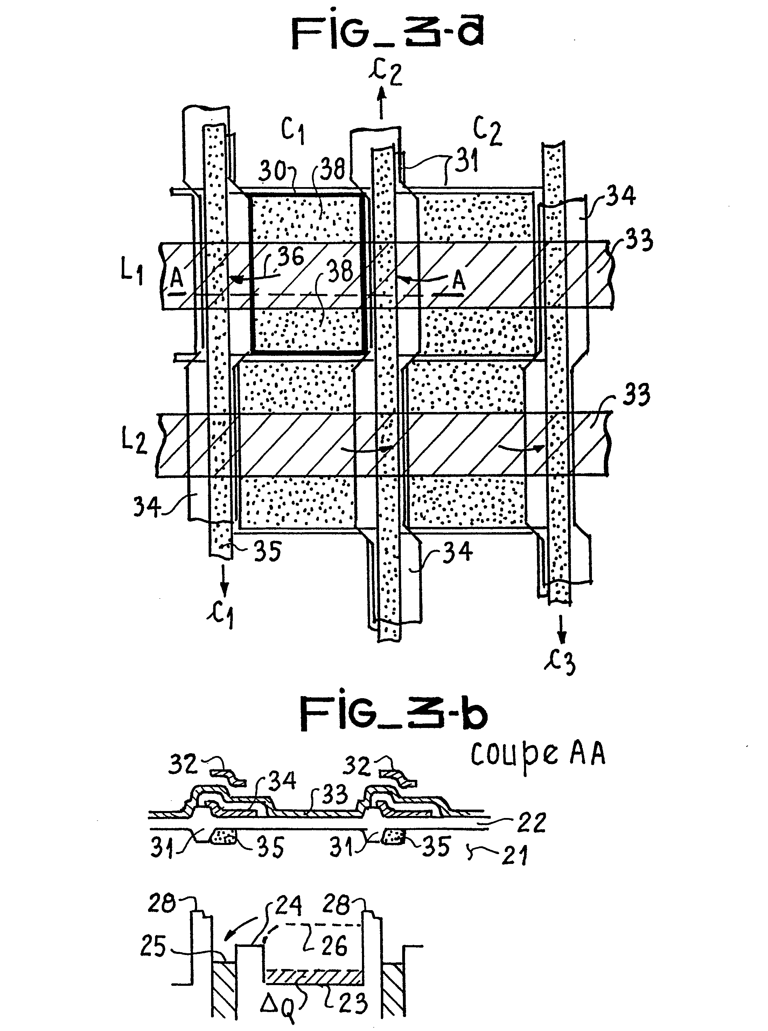

La fig. 3a représente un mode de réalisation d'une matrice de points photosensibles susceptibles d'être utilisée dans le dispositif de la fig. 2.

Sur cette figure, on a représenté, déposés sur un substrat semi-conducteur (non représenté), en silicium par exemple, recouvert d'une couche isolante, en oxyde de silicium par exemple, plusieurs dépôts conducteurs 33, appelés ci-dessous comme les différents dépôts conducteurs du dispositif, électrodes ou grilles, métalliques éventuellement semi-transparents ou en silicium polycristallin, parallèles, représentant les lignes L de la matrice 1 de la fig. 2 (les lignes $L_1$ et $L_2$ de la figure précédente, par exemple) et constituant, avec le substrat semi-conducteur et l'isolant, des capacités MOS photodétectrices. Selon les colonnes C de la matrice (par exemple $C_1$, $C_2$ et $C_3$) sont placées des grilles 34, portées à un potentiel constant, qui constituent un écran pour les charges, selon un processus décrit plus en détail ci-dessous. Le dispositif comporte encore sous chacune des grilles-écrans 34 une bande 35 réalisée dans le substrat semi-conducteur, par dopage par exemple, constituant une diode permettant de réaliser la lecture des différents points photosensibles reliés à la colonne considérée.

Les différentes lignes L et les différentes colonnes C sont séparées les unes des autres par des barrières d'isolement 31 en forme de créneaux verticaux, représentées sur la figure en doubles traits, dont les parties horizontales sont sensiblement au milieu de l'espace séparant deux grilles 33, et les parties verticales sont alternativement à gauche ou à droite des grilles-écrans 34, sans les traverser. Chacune des barrières d'isolement 31 peut être réalisée par une surépaisseur locale de l'isolant, éventuellement accompagnée par un surdopage du substrat semi-conducteur, du même type de conductivité que celui-ci (par exemple surdopage $P^+$ pour un substrat P), le surdopage intervenant sous la surépaisseur d'oyde.

On a représenté, à titre d'exemple, en traits épais un point photosensible, repéré 30: il est limité horizontalement par la barrière d'isolement 31, sur l'un de ses côtés verticaux (côté droit dans l'exemple de la figure) par la même barrière d'isolement, et sur son autre côté vertical par la grille-écran 34. Selon un processus décrit ci-dessous, le point 30 est lu par la diode-colonne 35 située à sa gauche comme l'indique une flèche 36 sur la figure. Dans la variante de réalisation représentée sur la figure, chacune des grilles-écrans 34 est non pas en forme de bande rectangulaire, mais légèrement en forme de créneaux verticaux, comme les barrières d'isolement 31, mais de beaucoup plus faible amplitude, afin de permettre un maximum de surface photosensible: en effet, il existe un minimum de largeur pour la grille-écran entre le point photosensible et la diode de lecture 35, mais cette largeur n'est bien entendu requise que du côté où ce point est lu, par exemple côté gauche (flèche 36) pour le point 30 de la figure.

Le point photosensible 30 est donc formé d'une capacité MOS (substrat semi-conducteur, isolant et grille 33) constituant une première zone de collection de charges, et d'une seconde zone de collection de charges repérée 38, constituée de deux parties situées entre la grille 33 et les barrières d'isolement 30. En effet, la capacité MOS a une grande capacité de stockage de charges et permet ainsi d'obtenir une bonne dynamique pour chaque point photosensible, mais la grille 33 présente une absorption plus grande pour les faibles longueurs d'onde, dont on s'affranchit par la seconde zone de collection de charges. Dans une variante de réalisation, on forme dans cette zone 38 une photodiode, par exemple par dopage du substrat, permettant d'accroître la sensibilité du point. Cette photodiode peut être réalisée seulement dans l'espace 38 compris entre la grille 33 et les barrières d'isolement 30; elle peut également s'étendre sous la grille 33 afin d'améliorer le couplage électrique entre capacité MOS et photodiode. Ces différentes variantes de réalisation de la seconde zone de collection des charges sont également applicables aux différents modes de réalisation de la matrice photosensible, décrits plus loin.

La fig. 3b représente une vue en coupe de la fig. 3a réalisée selon une ligne AA, coupant le point photosensible 30 au niveau de la grille de capacité MOS 33.

Sur cette figure, la structure du dispositif de la fig. 3a apparaît plus clairement: il est réalisé dans un substrat semi-conducteur 21, recouvert d'une couche isolante 22, deux barrières d'isolement 31 par surépaisseur d'isolant et une diode de lecture 35 à la droite de chacune des barrières 31, par dopage du substrat. Sur la couche isolante 22 sont disposées les grilles-écrans 34 en bordure et à droite des barrières d'isolement 31. La grille de la capacité MOS 33 s'étend sur le substrat et au-dessus des grilles-écrans 34, par l'itnermédiaire d'une couche d'isolant, non représentée pour la clarté du dessin.

Le dispositif comporte en outre une métallisation 32 déposée sur la grille 33, par l'intermédiaire d'une couche d'isolant, au droit de chacune des diodes 35 et représentée uniquement à la fig. 3b. Ces bandes métalliques 32 ont pour fonction de constituer un écran opaque aux rayonnements lumineux qui seraient susceptibles de créer des charges parasites dans les diodes de lecture 35. Elles peuvent être réalisées par exemple en aluminium.

Le fonctionnement du dispositif représenté sur la fig. 3a sera plus clairement expliqué à l'aide du profil du potentiel de surface qui est représenté sous la coupe de la fig. 3b.

Sur ce diagramme, les potentiels sont représentés croissant vers le bas du schéma, ce qui correspond au fait que, appliqués sur une électrode, ils créent un puits de potentiel permettant d'emprisonner les charges.

Lorsqu'une ligne n'est pas adressée par le regisre 14 (fig. 1), son potentiel est à une valeur donnée représentée par la ligne 23 sur le schéma de la fig. 3b, au droit de la grille de la capacité MOS 33, limitée de part et d'autre par des potentiels plus faibles: un potentiel représenté par une ligne 28, correspondant aux barrières d'isolement 31, et un potentiel constant $V_E$ appliqué à la grille-écran 34, représenté par une ligne 24, dont la valeur est choisie plus faible que la valeur appliquée à la grille 33 de façon à former un puits de potentiels sous cette grille, dans lequel les charges créées par l'éclairement peuvent être stockées (zone hachurée repérée $\Delta Q$ sur la figure). Au droit de la diode de lecture 35, le potentiel est, avant lecture du point photosensible considéré, ramené à une valeur donnée illustrée par le niveau 25, par les moyens de remise à niveau schématisés sur la fig. 1, la valeur de ce potentiel devant être plus élevée que celle du potentiel $V_E$ afin qu'il n'y ait pas invasion par des charges parasites des puits de potentiels situés au droit des grilles 33.

Lorsque le point photosensible considéré est, en même temps que tous les points photosensibles de la ligne à laquelle il appartient, sélectionné par le registre 14, le potentiel qui est appliqué à la grille 33 est ramené à une valeur proche de zéro, ce qui est illustré par la ligne 26 sur la fig. 3b: ce potentiel étant alors inférieur à $V_E$ (ligne 24), les charges accumulées lors de la phase précédente sont donc déversées dans la diode 35, comme indiqué par une flèche sur la fig. 3b, pour être évacuées vers l'une des mémoires de ligne 27 ou 29; dans l'exemple de la figure, les charges sont évacuées par l'intermédiaire de la colonne $c_1$ vers la mémoire de ligne 27.

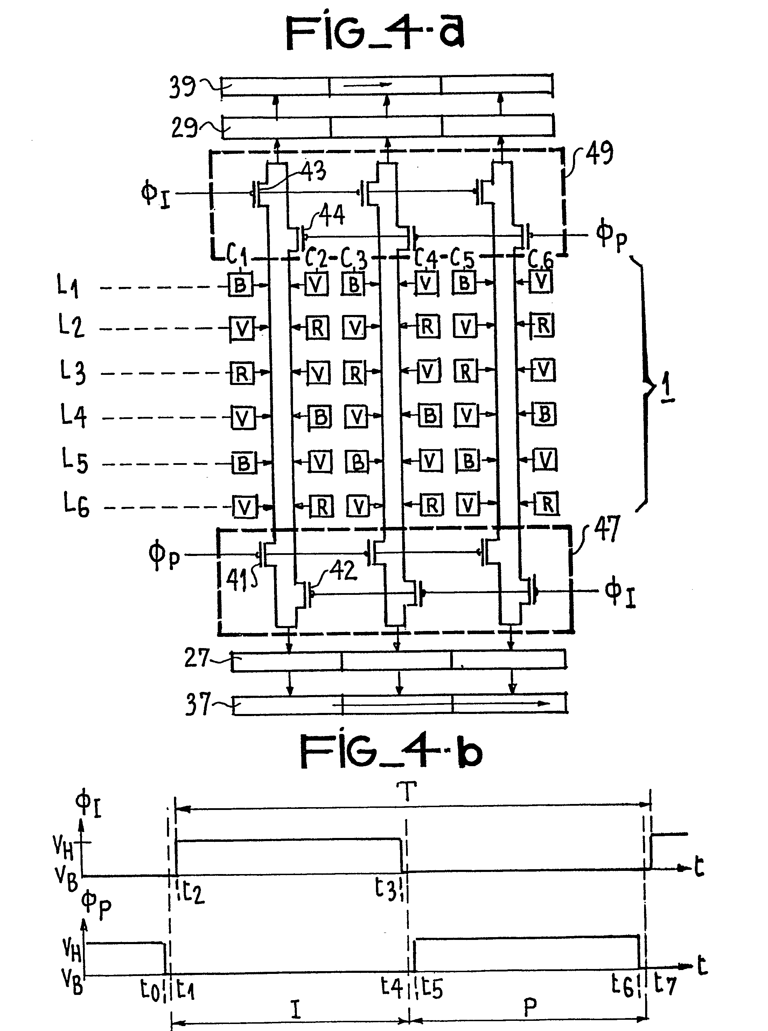

La fig. 4 représente un autre mode de réalisation du dispositif selon l'invention, adapté au cas où la lecture de la zone photosensible se fait par demi-trames entrelacées, c'est-à-dire en commençant par la demi-trame constituée par les lignes d'ordre impair (demi-trame impaire) puis en suivant par la demi-trame constituée par les lignes d'ordre pair (demi-trame paire). En effet, dans ce cas, chacune des lignes d'un dispositif tel que celui de la fig. 2 devrait être dédoublée pour obtenir à chaque demi-trame un signal identique, ce qui est nécessaire pour une bonne qualité de l'image à la restitution.

Dans le schéma de la fig. 4, on retrouve une matrice 1 de six lignes (L) et six colonnes (C) de points photosensibles 15 à chacun desquels est affectée une couleur (R, V ou B), les points photosensibles verts étant répartis de la même façon que précédemment. Les points restants sont répartis de telle sorte qu'une ligne soit seulement bicolore (vert et bleu ou vert et rouge), l'information de couleur ne variant qu'une fois toutes les deux lignes: par exemple, la ligne $L_1$ comporte alternativement un point vert et un point bleu, et aucun point rouge; la ligne $L_2$ comporte alternativement des points rouges et verts, et aucun point bleu; de même pour la ligne $L_3$; les lignes $L_4$ et $L_5$ sont à nouveau alternativement bleues et vertes, la ligne $L_6$ étant alternativement rouge et verte, le point de la ligne $L_1$ et de la colonne $C_1$ étant par exemple un point bleu.

De plus, à l'aide de deux dispositifs d'aiguillage 47 et 49, le signal collecté sur chacune des colonnes peut être dirigé soit vers la mémoire de ligne 27, soit vers la mémoire de ligne 29. Ainsi, en commandant les dispositifs 47 et 49 de façon appropriée, décrite plus en détail ci-dessous, il est obtenu dans la mémoire de ligne 27 et donc en sortie du registre à décalage 37 associé, uniquement un signal représentant l'information de chrominance verte d'où l'on déduit l'information de luminance, et sur la mémoire de ligne 29 et donc en sortie du registre à décalage 39, successivement une ligne bleue puis une ligne rouge dans une même demi-trame. La séparation des couleurs est alors complète et l'alternance des lignes rouges puis bleues est adaptée au procédé SECAM.

En outre, contrairement au mode de réalisation de la fig. 2, tous les points photosensibles 15 d'une même colonne sont, dans le mode de réalisation de la fig. 4a, tous reliés à la même connexion de colonne.

De plus est représentée sur la fig. 4a une variatne de réalisation qui consiste à regrouper les connexions de colonne par deux entre les colonnes de points photosensibles, ce qui permet d'augmenter la surface photosensible par rapport à celle qui est réservée à la lecture.

Dans cet exemple de réalisation, le dispositif d'aiguillage 47 est constitué par six dispositifs interrupteurs, par exemple des transistors MOS, placés respectivement sur les six colonnes ($C_1$ à $C_6$), ceux qui sont placés sur les colonnes impaires, repérés 41, étant commandés par un potentiel $\phi_P$ appliqué sur leur grille, et ceux qui sont placés sur les colonnes paires, repérés 42, sont commandés par un potentiel $\phi_I$ également appliqué sur leur grille. De façon analogue, le dispositif d'aiguillage 49 est constitué par six transistors MOS interposés sur les six colonnes $C_1$ à $C_6$ respectivement, les transistors des colonnes impaires (43) étant commandés par le signal $\phi_I$ et les transistors des colonnes paires (44) par le signal $\phi_P$. Ces transistors sont polarisés en triode au moment de leur ouverture par les signaux $\phi_I$ et $\phi_P$.

Sur la fig. 4b, on a représenté le potentiel $\phi_I$ en fonction du temps; c'est une fonction en créneaux de période T, variant entre une valeur inférieure notée $V_B$ et une valeur supérieure notée $V_H$, la durée (entre les instants $t_2$ à $t_3$ sur la figure) du créneau supérieure ($V_H$) étant légèrement inférieure à T/2. Le potentiel $\phi_P$ est, de façon analogue, un signal en créneaux variant entre une valeur inférieure $V_B$ et une valeur supérieure $V_H$, qui sont par exemple égales à celles du signal $\phi_I$, la période de $\phi_P$ étant égale à la période T et la durée (des instants $t_5$ à $t_6$) du créneau supérieur $V\phi_H$), inférieure à T/2. Le signal $\phi_P$ est en opposition de phase avec le signal $\phi_I$, c'est-à-dire que le créneau bas ($V_B$) commence à un instant $t_0$ antérieur à l'instant $t_2$, et que le créneau supérieur ($V_H$) commence à l'instant $t_5$ postérieur à l'instant $t_3$.

La durée de la lecture d'une trame est égale à T; la lecture de la demi-trame impaire (lignes $L_1$, $L_3$ et $L_5$) est réalisée entre des instants $t_1$ et $t_4$, $t_1$ étant compris entre $t_0$ et $t_2$ et $t_4$ entre $t_3$ et $t_5$, la lecture de la demi-trame paire (lignes $L_2$, $L_4$ et $L_6$) s'opérant entre les instants $t_4$ et $t_7$, $t_7$ étant analogue à l'instant $t_1$; la durée de la demi-trame impaire est repérée I sur le schéma, et la durée de la demi-trame paire par P.

Pendant la demi-trame impaire (I),le signal $\phi_I$ est au niveau haut ($V\phi_H$), ce qui se traduit par l'orientation des charges stockées dans les points bleus et rouges des colonnes impaires vers la mémoire de ligne 29 grâce aux transistors 43 qui, commandés par $\phi_I$, sont alors conducteurs, les transistors 41, commandés par $\phi_P$ alors au niveau bas, interdisant l'accès à la mémoire 27. Pendant ce même temps, les colonnes paires qui comportent des points sensibles au vert sur les lignes impaires sont lues en direction de la mémoire de ligne 27 seulement grâce aux transistors 42 qui sont alors conducteurs, alors que les transistors 44 ne le sont pas.

Pendant la demi-trame paire (P) suivante, le fonctionnement est inversé: les colonnes impaires qui comportent sur les lignes paires des points verts sont lues en direction de la mémoire de ligne 27 grâce aux transistors 41 qui sont alors conducteurs, le signal $\phi_P$ étant au niveau haut, alors que le signal $\phi_I$ est au niveau bas, interdisant l'accès à la mémoire de ligne 29 (transistors 43 non conducteurs). Pendant ce même temps, la lecture des colonnes paires qui portent sur les lignes paires alternativement des points rouges et bleus est lue en direction de la mémoire de ligne 29 grâce aux transistors 44 conducteurs, les transistors 42 non conducteurs interdisant l'accès à la mémoire de ligne 27.

Chacune des lignes ne comportant que des ponts sensibles au vert et à l'une des autres couleurs seulement, il apparaît que le registre 37, relié à la mémoire 27, ne reçoit que le signal correspondant au vert, alors que la mémoire de ligne 29 et donc le registre 39 fournit alternativement une ligne bleue et une ligne rouge. Il est à noter que cette caractéristique est indépendante du regroupement des connexions de colonne.

Dans une variante de réalisation, non représentée, il est possible de dédoubler chaque ligne de la structure de la fig. 4a, l'une des lignes d'une même paire appartenant à la demi-trame impaire et l'autre à la demi-trame paire. Dans une même demi-trame, tous les points verts par exemple sont, d'une ligne à l'autre, reliés tantôt aux connexions de colonnes paires, tantôt aux impaires.

Pour obtenir le même résultat que précédemment, c'est-à-dire tous les points verts reliés à la mémoire 27 par exemple, la période (T) des signaux $\phi_I$ et $\phi_P$ ne doit plus être la période trame, mais la période ligne.

L'avantage de cette variante est que, alors, la structure colorée de deux demi-trames est parfaitement identique. En outre, la résolution verticale peut être deux fois plus faible pour les filtres colorés, ceux-ci pouvant alors s'étendre sur deux lignes à la fois.

Dans une autre variante de réalisation non représentée, la répartition des filtres colorés diffère de la fig. 4a en ce sens que les filtres verts sont maintenant placés en colonnes.

Les points photosensibles d'une même colonne sont toujours reliés à la même connexion de colonne, reliée à l'une des deux mémoires de lignes, et la lecture se fait par demi-trames entrelacées. Il n'y a plus besoin de dispositifs d'aiguillage pour obtenir sur l'une des sorties du vert et sur l'autre sortie des lignes bleues et rouges alternées.

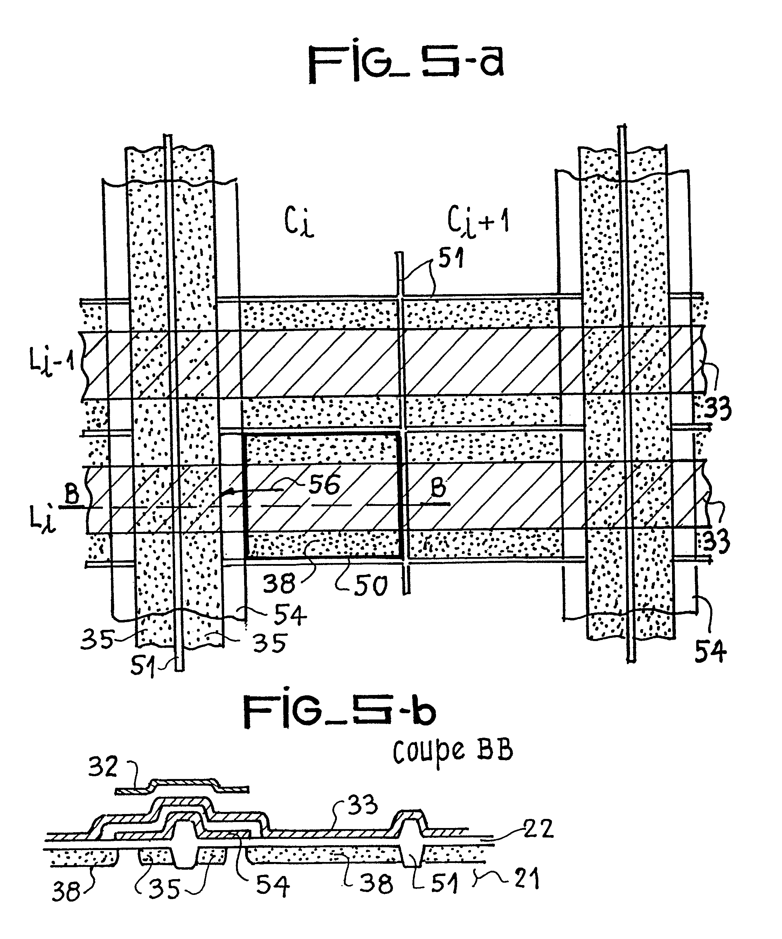

La fig. 5a représente une vue de dessus et la fig. 5b une vue en coupe d'un mode de réalisation d'une matrice de points photosensibles dans laquelle est opéré le regroupement des connexions de colonne illustré sur la fig. 4a.

Les différences avec la matrice représentée fig. 3a se situent donc au niveau des colonnes de collection des charges. On retrouve donc sur la fig. 5a les grilles 33, séparées les unes des autres par des barrières d'isolement 51 réalisées comme précédemment. Entre les grilles 33 et les barrières d'isolement 51 sont situées les zones 38 dans lesquelles sont réalisées, dans la variante représentée, des photodiodes. L'un des points photosensibles ainsi constitués est entouré d'un trait épais et repéré 50 sur la fig. 5a: il appartient à la ligne $L_i$ et

à la colonne $C_i$ et les charges qu'il stocke sont lues vers la gauche comme représenté par une flèche 56.

Comme représenté fig. 5a, les colonnes de lecture sont regroupées par deux de part et d'autre d'une barrière d'isolement verticale, également repérée 51. On trouve donc, de part et d'autre de l'isolement 51, deux diodes-colonnes repérées 35 et réalisées comme précédemment, par exemple dans le substrat 21 (fig. 5b). La grille-écran est maintenant repérée 54 et recouvre à la fois la barrière d'isolement 51 et les deux diodes de lecture 35 qui se trouvent de part et d'autre de la barrière 51. Comme il apparaît plus clairement sur la fig. 5b, la grille de capacités MOS 33 recouvre le substrat 21 et les grilles-écrans 54, par l'intermédiaire d'une couche d'isolant. Comme précédemment, une couche opaque 32 est placée au-dessus des diodes de lecture 35; dans le cas présent, il est déposé une seule couche 32 pour les deux diodes de lecture situées de part et d'autre d'une même barrière 51.

A titre d'exemple, on a représenté sur la fig. 5b le cas où, dans les zones 38, sont réalisées des photodiodes qui s'étendent également sous la grille de capacités MOS 33, en dehors des zones occupées par les grilles-écrans 54 et les barrières d'isolement 51.

Enfin, bien entendu, les barrières d'isolement 51 horizontales s'interrompent au niveau des diodes de lecture 35.

Le fonctionnement d'un tel point photosensible est analogue à celui qui a été décrit pour la fig. 3.

Ce regroupement des colonnes permet un accroissement de sensibilité assez important, du fait que la surface disponible pour les points photosensibles est plus grande: en effet, deux points photosensibles directement adjacents ne sont séparés que par une barrière d'isolement verticale 51 qui peut être très mince et qui n'a pas à être recouverte par un dépôt opaque tel que 32.

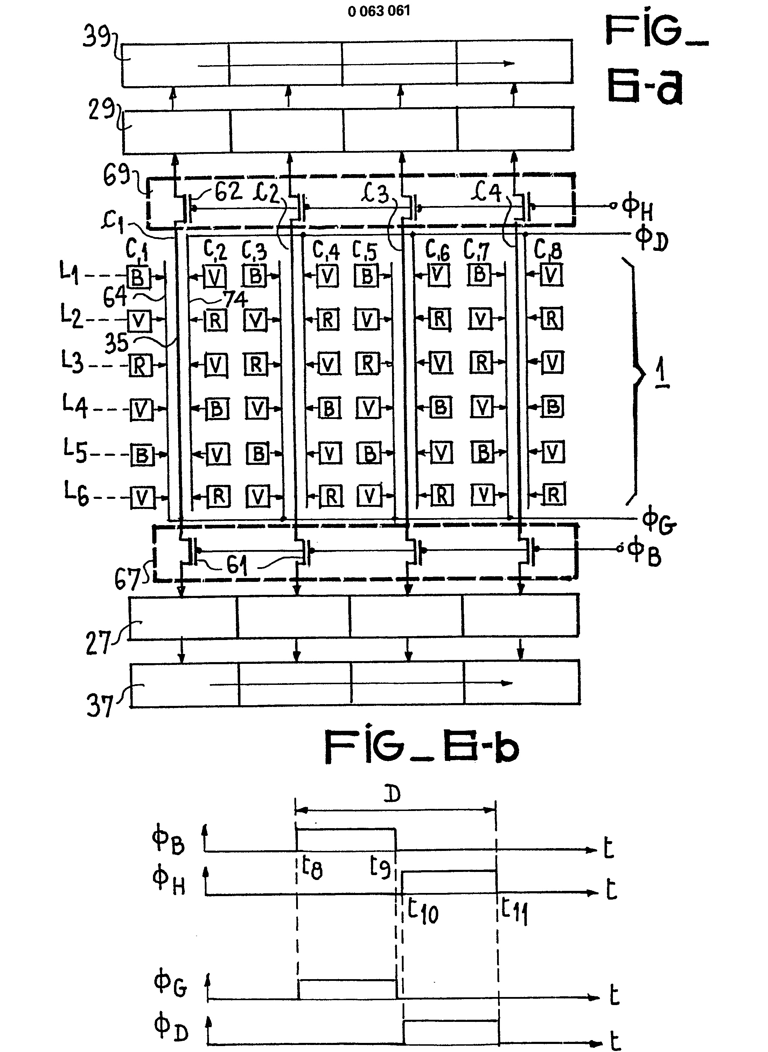

La fig. 6a représente une variante du mode de réalisation de la fig. 4a dans laquelle la double colonne est remplacée par une colonne unique, l'isolement entre les points photosensibles étant réalisé par des grilles-écrans indépendantes.

Sur la fig. 6a, on retrouve donc la matrice photosensible 1 qui comporte par exemple six lignes ($L_1$ à $L_6$) et huit colonnes ($C_1$ à $C_8$), les filtres colorés étant répartis de la même façon que sur la fig. 4a, et les deux mémoires de ligne 27 et 29 situées de part et d'autre de la matrice 1, reliées respectivement aux deux registres à décalage 37 et 39.

Le dispositif comporte ici deux éléments d'aiguillage 67 et 69 interposés respectivement avant les mémoires de ligne 27 et 29. Les colonnes $C_1$ à $C_8$ que constituent les points photosensibles sont reliées deux par deux à une même connexion de colonne ($c_1$ à $c_4$ sur la figure), qui comporte une diode de lecture 35, illustrée sur la fig. 6a par une simple connexion, entourée de deux grilles-écrans de part et d'autre de la diode de lecture 35, ces grilles étant repérées 64 pour la colonne $C_1$ et 74 pour la colonne $C_2$. Les grilles-écrans telles que 64, qui correspondent aux colonnes impaires ($C_1$, $C_3$, $C_5$, $C_7$), sont reliées à un potentiel $\phi_G$, et les grilles-écrans telles que 74 reliées aux colonnes paires ($C_2$, $C_4$, $C_6$ et $C_8$) sont reliées à un potentiel $\phi_D$. Les diodes de lecture 35 sont reliées, à chacune de leurs extrémités, respectivement aux mémoires 27 et 29 par l'intermédiaire de transistors 61 et 62, commandés respectivement par des potentiels $\phi_B$ et $\phi_H$, ces transistors constituant respectivement les dispositifs d'aiguillage 67 et 69.

La fig. 6b représente la forme des signaux de commande $\phi_B$, $\phi_H$, $\phi_G$ et $\phi_D$ utilisés dans le dispositif de la fig. 6a, qui sont des tensions évoluant entre un niveau haut et un niveau bas.

Pendant la durée D de retour ligne, entre des instants repérés $t_8$ et $t_{11}$, le signal $\phi_B$ n'est à l'état haut qu'entre l'instant $t_8$ et un instant $t_9$, $t_9-t_8$ étant légèrement inférieur à D/2; les signal $\phi_H$ n'est à l'état haut qu'entre un instant $t_{10}$ et l'instant $t_{11}$, avec $t_{112}-t_{10}$ légèremnt inférieur à D/2; le signaux $\phi_G$ et $\phi_D$ ont respectivement même forme que les signaux $\phi_B$ et $\phi_H$.

Le fonctionnement du dispositif est le suivant.

Pour l'une des demi-trames, paire ou impaire, on a par exemple le signal $\phi_B$ au niveau haut en même temps que le signal $\phi_G$, de sorte que les charges stockées dans les points photosensibles des colonnes (C) impaires seront aiguillées vers la mémoire de ligne 27, les transistors 61, commandés par $\phi_B$, étant alors conducteurs. Pendant cette même période, le signal $\phi_D$ étant au niveau bas, les colonnes paires sont isolées des diodes 35 par la grille-écran 74, et l'accès à la mémoire de ligne 29 est fermé par les transistors 62, commandés par le signal $\phi_H$, qui ne sont pas conducteurs. A l'instant $t_{10}$, les signaux $\phi_B$ et $\phi_G$ sont revenus au niveau bas alors que les signaux $\phi_H$ et $\phi_D$ sont au niveau haut et le fonctionnement est alors inverse du précédent, c'est-à-dire que ce sont les charges stockées dans les points photosensibles des colonnes paires qui sont évacuées par la diode 35 et elles sont dirigées vers la mémoire de ligne 29 exclusivement par l'intermédiaire des transistors 62, seuls conducteurs.

Pendant la demi-trame suivante, pour obtenir un fonctionnement analogue à ce qui a été expliqué fig. 4b, il est nécessaire d'inverser l'une des couples de signaux $\phi_B$-$\phi_H$ ou $\phi_G$-$\phi_D$: par exemple, il est possible de conserver $\phi_B$ et $\phi_H$ au niveau haut dans le même ordre, mais alors $\phi_D$ doit être en phase avec $\phi_B$ et $\phi_G$ doit être en phase avec $\phi_H$.

Par ailleurs, de façon analogue à ce qui a été décrit pour la fig. 4a, il est possible de dédoubler chaque ligne de la matrice 1, en adaptant les signaux de commande, de façon notamment à obtenir des structures colorées parfaitement identiques d'une demi-trame à l'autre.

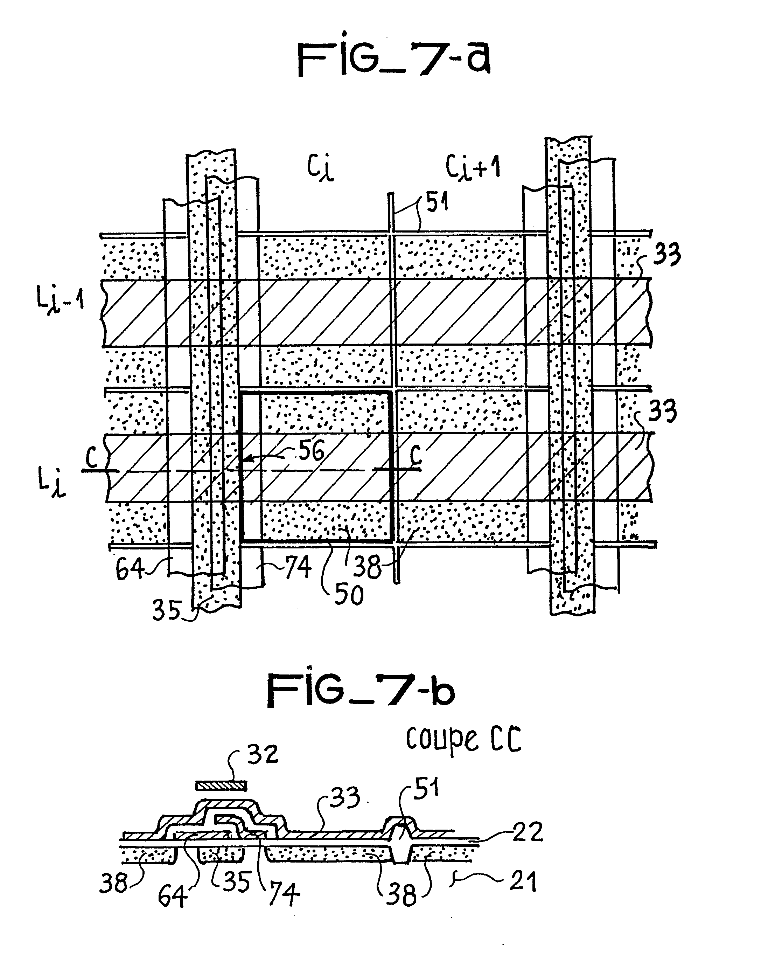

La fig. 7a représente une vue de dessus et la fig. 7b une vue en coupe d'un mode de réalisation d'une matrice photosensible susceptible d'être utilisée dans le dispositif de la fig. 6a.

Cette structure ne diffère de celle de la fig. 5a qu'au niveau des colonnes collectrices de charges. On retrouve donc le point photosensible 50 constitué par une capacité MOS réalisée par la grille 33, le substrat semi-conducteur 21 et l'isolant 22, et une zone 38 dans laquelle on a réalisé une photodiode qui s'étend par exemple également sous la grille 33, limitée par les éléments 51 et 74, comme représenté sur la coupe de la fig. 7b, réalisée dans le dispositif de la fig. 7a selon une ligne CC, au niveau du point photosensible 50 et de la grille 33. Comme précédemment, la lecture de ce point s'effectue par la gauche (flèche 56).

La colonne de collection des charges est ici constituée par une diode-colonne 35 recouverte en partie par la grille-écran 64, celle-ci s'étendant également au-dessus du substrat 21 à gauche de la diode de lecture 35. La grille-écran 74 recouvre l'autre partie de la diode 35, s'étend sur une partie du substrat situé à droite de cette diode et s'étend également, par l'intermédiaire d'une couche d'isolant, au-dessus de la grille-écran 64. Comme précédemment, l'ensemble est recouvert de la grille 33, au-dessus de laquelle est encore disposée la couche opaque 32 par l'intermédiaire d'une couche d'isolant, au niveau de la diode 35.

L'avantage de la structure telle que décrite fig. 6 et 7 est la suppression de l'isolation entre deux colonnes et, par suite, un accroissement de la sensibilité. A titre d'exemple, cet accroissement peut atteindre 30% par rapport à une structure telle que celle de la fig. 3.

L'invention n'est pas limitée aux modes de réalisation décrits ci-dessus, mais englobe toutes les variantes qui sont à la portée de l'homme de l'art. C'est ainsi que l'arrangement des filtres colorés a été décrit avec les trois couleurs classiques vert, bleu et rouge, mais peut bien entendu être appliqué aux trois couleurs complémentaires des précédentes, ou à d'autres ensembles de trois couleurs, tels que vert, jaune et blanc ou vert, jaune et cyan par exemple.

## Revendications

1. Dispositif d'analyse d'images en couleurs, utilisant le transfert de charges électriques, comportant un ensemble photosensible formé d'une pluralité de zones photosensibles élémentaires, appelées points (15), dans lesquelles sont créées des charges électriques en fonction de l'éclairement reçu, réalisées sur un même substrat semi-conducteur (21) selon N lignes (L) et M colonnes (C) et isolées les unes des autres, formant une matrice (1), chaque point recevant un filtre coloré (R, V, B) destiné à ne le rendre sensible qu'à une couleur prédéfinie, caractérisé en ce que:
— chacune de ces zones élémentaires (15) comporte une capacité MOS (33-21-22), constituant une première zone de collection de charges et comporte une grille (33) qui est commune aux capacités d'une même ligne, et une seconde zone de collection de charges (38), électriquement couplée à la capacité;
— des moyens de connexion et de commande assurent la fourniture en parallèle par l'intermédiaire de connexions de colonne des charges électriques créées dans les M points d'une même ligne, successivement pour les N lignes, ces moyens comportant une pluralité de diodes de lecture (35), arrangées en colonnes entre les points de façon à recevoir chacune, successivement, sur commande, les charges d'au moins deux points appartenant à deux lignes différentes;
— des moyens formant écran pour les charges sont placés entre chacun des points et les moyens de connexion, ces moyens-écrans comportant une pluralité de grilles (34, 54, 64, 74) arrangées en colonnes entre les diodes de lecture et les points et portées à un potentiel constant ($V_E$, $\phi_G$, $\phi_D$), au moins lors du transfert des charges des points vers les moyens de connexion:
— deux mémoires (27, 29) dites mémoires de ligne, réalisées dans le même substrat semiconducteur (21), reçoivent en parallèle les charges électriques fournies par les moyens de connexion et de commande, de telle sorte que chaque point de la matrice soit affecté à l'une seulement des deux mémoires de ligne, l'une de ces mémoires (27) n'étant reliée qu'aux points d'une même couleur;
— deux registres à décalage analogiques (37, 39), reçoivent en parallèle respectivement les charges fournies par les deux mémoires de ligne et délivrent en série chacun un signal électrique d'analyse de l'image.

2. Dispositif selon la revendication 1, caractérisé par le fait que les filtres colorés (V, B, R) respectivement placés sur les points photosensibles (15) rendent ceux-ci sensibles respectivement à une première, une deuxième et une troisième couleur, l'une des mémoires de ligne n'étant reliée qu'aux points de la première couleur.

3. Dispositif selon la revendication 2, caractérisé par le fait que les points (15) d'une même ligne (L) sont arrangés selon la séquence première — troisième — première — deuxième couleur (V, R, V, B), les points de la première couleur (V) étant placés en quinconce d'une ligne à l'autre, les points d'une même colonne (C) étant reliés alternativement aux connexions de colonne (c) situées à droite et à gauche de la colonne (C) de points considérée, de sorte que l'une des mémoires de ligne (27) ne soit connectée qu'aux points de la première couleur (V), l'autre mémoire de ligne étant connectée à la fois aux points des deux autres couleurs (B et R).

4. Dispositif selon la revendication 3, caractérisé par le fait que les moyens formant écran comportent une grille (34), portée à un potentiel constant ($V_E$), en forme de bande par colonne, les diodes de lecture (35) étant également en forme de bande, de largeur inférieure aux précédentes, formées dans le substrat semi-conducteur (21) sous chacune des grilles-écrans (34), l'isolement (31) des points photosensibles les uns par rapport aux autres étant réalisé horizontalement entre deux grilles de capacité MOS (33), de façon continue sauf au niveau des diodes de lecture (35), et verticalement de façon continue, en créneau autour de chacun des points photosensibles (30).

5. Dispositif selon la revendication 2, caractérisé par le fait que les points (15) d'une même ligne sont alternativement des première et deuxième couleurs, pour deux lignes successives, puis des première et troisième couleurs pour les deux lignes suivantes, et ainsi de suite, les points de la première couleur (V) étant placés en quinconce d'une ligne à l'autre, les points (15) d'une même colonne (C) étant reliés ensemble aux deux mémoires de ligne (27, 29) par l'intermédiaire respectivement de deux dispositifs d'aiguillage (47, 49), assurant l'affectation pour les lignes impaires des colonnes impaires à l'une des mémoires de ligne et des colonnes paires à l'autre des mémoires, le processus étant inversé par les lignes paires, de sorte que l'une des mémoires (27) ne reçoit de charges qu'en provenance des points de la première couleur (V) et l'autre mémoire (29) reçoit des lignes ne comportant chacune qu'une seule des autres couleurs, en alternance.

6. Dispositif selon la revendication 2, caractérisé par le fait que les points (15) d'une même ligne sont alternativement des première et deuxième couleurs, pour deux lignes successives, puis des première et troisième couleurs pour les deux lignes suivantes, et ainsi de suite, les points de la première couleur (V) étant placés en colonnes, les points (15) d'une même colonne (C) étant reliés ensemble à l'une des deux mémoires de ligne (27, 29), l'une des mémoires (27) ne recevant de charges qu'en provenance des points de la première couleur (V) et l'autre mémoire (29) recevant des lignes ne comportant qu'une seule des autres couleurs, en alternance.

7. Dispositif selon l'une des revendications 3 ou 5, caractérisé par le fait que les connexions de colonne (c) sont regroupées deux par deux entre les colonnes (C) de points (15).

8. Dispositif selon les revendications 5 et 6, caractérisé par le fait que les moyens formant écran comportent une grille (54) en forme de bande par colonne, portée à un potentiel constant $(V_E)$, les diodes de lecture (35) étant également en forme de bande, de largeur inférieure aux précédentes, formées dans le substrat semi-conducteur (21) et réunies deux par deux sous chacune des grilles-écrans (54), l'isolement (51) des points photosensibles (50) les uns par rapport aux autres étant réalisé horizontalement entre deux grilles de capacité MOS (33), de façon continue sauf au niveau des diodes de lecture (35), et verticalement de façon continue entre deux diodes de lecture (35) adjacentes et entre deux points photosensibles (50) adjacents.

9. Dispositif selon la revendication 5, caractérisé par le fait que les moyens de connexion ne comportent qu'une seule connexion de colonne (c) pour deux colonnes de points (C) et une seule diode de lecture (35) en forme de bande, les moyens formant écran comportant une grille par colonne, les deux grilles (64, 74) relatives à une même diode (35) étant soumises à des potentiels en opposition de phase $(\phi_G, \phi_D)$ afin de réaliser séquentiellement la lecture des points reliés à une même connexion de colonne (c), les connexions de colonne étant reliées aux deux mémoires de ligne (27, 29) par l'intermédiaire respectivement des deux dispositifs d'aiguillage (67, 69) assurant pour une même ligne l'aiguillage des charges vers l'une des mémoires de ligne en fonction du point dont elles proviennent.

10. Dispositif selon l'une des revendications précédentes, caractérisé par le fait que les secondes zones de collection des charges (38) de chaque point photosensible (30, 50) sont situées aux emplacements du point photosensible laissés libres par la grille-écran (34, 54, 64, 74) et la grille de la capacité MOS (33).

11. Dispositif selon l'une des revendications précédentes, caractérisé par le fait que chacune des secondes zones de collection des charges (38) est constituée par une diode.

12. Dispositif selon la revendication 11, caractérisé par le fait que la diode s'étend en outre sous la grille de la capacité MOS (33) de chacun des points photosensibles.

13. Dispositif selon l'une des revendications précédentes, caractérisé par le fait que l'isolement (31, 51) est réalisé par une surépaisseur de la couche isolante (22) recouvrant le substrat semi-conducteur (21).

14. Dispositif selon la revendication 13, caractérisé par le fait que l'isolement (31, 51) comporte en outre un surdopage du substrat semi-conducteur (21), réalisé sous la surépaisseur de la couche isolante.

15. Dispositif selon l'une des revendications précédentes, caractérisé par le fait qu'il comporte, de plus, une bande opaque (32) à l'image lumineuse, de largeur au moins égale à celle des diodes de lecture (35), déposée au-dessus de la grille-écran (34, 54, 64, 74), pour chacune des connexions de colonne.

16. Dispositif selon la revendication 15, caractérisé par le fait que la bande opaque (32) à l'image lumineuse est réalisée en aluminium.

17. Dispositif selon l'une des revendications précédentes, caractérisé par le fait que les première, deuxième et troisième couleurs sont respectivement le vert, le bleu et le rouge.

18. Dispositif selon l'une des revendications précédentes, caractérisé par le fait que les registres à décalage sont des registres à transfert de charges du type CCD.

19. Caméra de télévision, caractérisée en ce qu'elle comporte un dispositif d'analyse d'image selon l'une des revendications précédentes.

**Patentansprüche**

1. Mit Übertragung elektrischer Ladungen arbeitende Farbenbildanalysiervorrichtung mit einer aus einer Mehrzahl von als Punkte (15) bezeichneten lichtempfindlichen Elementarzonen bestehenden lichtempfindlichen Baueinheit, bei der in diesen Elementarzonen in Abhängigkeit von der empfangenen Beleuchtung elektrische Ladungen erzeugt werden und diese Zonen auf einer gemeinsamen Trägerschicht aus Halbleitmaterial (21) längs eine Matrize bildender N-Zeilen (L) und M-Spalten (C) angeordnet und voneinander isoliert sind, wobei jeder Punkt mit einem Farbfilter (R, V, B) versehen wird, das den betreffenden Punkt nur für eine vorbestimmte Farbe empfindlich macht, gekennzeichnet durch folgende Merkmale:

— jede dieser Elementarzonen (15) besitzt einen MOS-Kondensator (33-21-22), der eine erste Ladungssammelzone bildet und ein allen Kondensatoren einer gegebenen Zeile gemeinsam zugeordnetes Gitter (33) sowie eine an den Kondensator angekoppelte zweite Ladungssammelzone (38);

— Verbindungs- und Steuermittel versorgen über Spaltenverbindungen nacheinander die N-Zeilen parallel mit den an den M-Punkten einer gegebenen Zeile erzeugten elektrischen Ladungen, und weisen eine Mehrzahl von Lesedioden (35) auf, die derart spaltenweise zwischen den Punkten angeordnet sind, dass alle Dioden nach Massgabe eines Steuerbefehls nacheinander die Ladungen wenigstens zweier zu zwei verschiedenen Zeilen gehörender Punkte empfangen;

— einen Schirm zur Abschirmung der Ladungen bildende Mittel sind zwischen jedem Punkt und den Verbindungsmitteln angeordnet und besitzen eine Mehrzahl von spaltenweise zwischen den Lesedioden und den Punkten angeordneten Gittern (34, 54, 64, 74), die wenigstens während der Übertragung der Ladungen von den Punkten auf die Verbindungsmittel auf ein konstantes Potential $(V_E, \phi_G, \phi_D)$ gebracht werden;

— zwei, Zeilenspeicher genannte, auf der gleichen Halbleiterträgerschicht (21) ausgebildete Speicher (27, 29) empfangen parallel die von den Verbindungs- und Steuermitteln gelieferten elektrischen Ladungen, derart, dass jeder Punkt der Matrize nur einem der beiden Zeilenspeicher beigeordnet ist, wobei einer dieser Speicher (27) nur mit den Punkten gleicher Farbe verbunden ist;

— zwei Analogverschiebungsregister (37, 39) empfangen parallel einerseits die von den beiden Zeilenspeichern gelieferten Ladungen und geben andererseits in Reihe je ein elektrisches Bildanalysesignal ab.

2. Vorrichtung nach Anspruch 1, dadurch gekennzeichnet, dass die an je einem der lichtempfindlichen Punkte (15) angeordneten Farbfilter (V, B, R) diese Punkte für jeweils eine erste, eine zweite und eine dritte Farbe empfindlich machen, wobei einer der Zeilenspeicher nur mit den Punkten der ersten Farbe verbunden ist.

3. Vorrichtung nach Anspruch 2, dadurch gekennzeichnet, dass die Punkte (15) einer gegebenen Zeile (L) gemäss der Reihenfolge erste — dritte — erste — zweite Farbe (V, R, V, B) angeordnet sind, wobei die Punkte der ersten Farbe (V) in je zwei gegebenen Zeilen gegeneinander versetzt angeordnet sind und die Punkte jeder Spalte (C) abwechselnd an die rechts und links der betreffenden Spalte (C) gelegenen Spaltenverbindungen (c) derart verbunden sind, dass einer der Zeilenspeicher (27) nur mit den Punkten der ersten Farbe (V) und der andere Zeilenspeicher zugleich mit den Punkten der beiden anderen Farben (B und R) verbunden ist.

4. Vorrichtung nach Anspruch 3, dadurch gekennzeichnet, dass die einen Schirm bildenden Mittel ein pro Spalte in Bandform ausgebildetes, auf ein konstantes Potential $(V_E)$ gebrachtes Gitter (34) darstellen, wobei die Lesedioden (35) ebenfalls bandförmig gestaltet sind und deren Bandbreite kleiner ist als diejenige des Gitters, und wobei diese Dioden unter jedem Schirmgitter (34) in der Halbleiterträgerschicht (21) ausgebildet sind und die jeweilige Isolierung (31) der einzelnen lichtempfindlichen Punkte zwischen je zwei MOS-Kondensatorgittern (33) horizontal und, abgesehen vom Bereich der Lesedioden (35) durchgehend, sowie durchgehend vertikal zinnenförmig um jeden lichtempfindlichen Punkt (30) herum ausgebildet ist.

5. Vorrichtung nach Anspruch 2, dadurch gekennzeichnet, dass die Punkte (15) jeder gegebenen Zeile für zwei aufeinanderfolgende Zeilen abwechselnd der ersten und der zweiten Farbe, und sodann für die beiden folgenden Zeilen der ersten und der dritten Farbe beigeordnet sind usw., wobei die Punkte der ersten Farbe (V) von einer Zeile zur nächsten gegeneinander versetzt angeordnet sind, während die zu einer gegebenen Spalte (C) gehörigen Punkte (15) gemeinsam mit den beiden Zeilenspeichern (27, 29) verbunden sind unter Zwischenschaltung je einer zweier Weichenschaltvorrichtungen (47, 49), die für die ungeraden Zeilen die ungeraden Spalten dem einen Speicher und die geraden Spalten dem anderen Speicher beiordnen, und wobei dieser Vorgang hinsichtlich der geraden Zeilen umgekehrt verläuft, so dass einer der Speicher (27) nur Ladungen von den Punkten der ersten Farbe (V) empfängt und der andere Speicher (29) von Zeilen gespeist wird, die abwechselnd nur je eine der anderen Farben aufweisen.

6. Vorrichtung nach Anspruch 2, dadurch gekennzeichnet, dass die Punkte (15) jeder gegebenen Zeile für zwei aufeinanderfolgende Zeilen abwechselnd der ersten und der zweiten Farbe und sodann für die beiden nachfolgenden Zeilen der ersten und der dritten Farbe beigeordnet sind usw., wobei die Punkte der ersten Farbe (V) spaltenweise angeordnet und die Punkte (15) jeder gegebenen Spalte (C) gemeinsam mit einem der beiden Zeilenspeicher (27, 29) verbunden sind, während einer dieser Speicher (27) nur Ladungen von den Punkten der ersten Farbe (V) und der andere Speicher (29) Zeilen empfängt, die abwechselnd nur eine der anderen Farben enthalten.

7. Vorrichtung nach einem der Ansprüche 3 oder 5, dadurch gekennzeichnet, dass die Spaltenverbindungen (c) paarweise zwischen den aus den Punkten (15) bestehenden Spalten (C) angeordnet sind.

8. Vorrichtung nach den Ansprüchen 5 und 6, dadurch gekennzeichnet, dass die den Schirm bildenden Mittel ein aus einem Band pro Spalte bestehendes Gitter (54) umfassen, das auf ein konstantes Potential $(V_E)$ gebracht wird, während die Lesedioden (35) ebenfalls die Form je eines Bandes besitzen, dessen Breite kleiner ist als diejenige der vorgenannten Bänder und das in der Halbleiterträgerschicht (21) ausgebildet ist, wobei diese Bänder paarweise unter jedem Schirmgitter (54) vereinigt sind und die Isolierung der einzelnen lichtempfindlichen Punkte (50) zwischen je zwei MOS-Kondensatorgittern (33) horizontal und abgesehen vom Bereich der Lesedioden (35) und zwischen zwei benachbarten lichtempfindlichen Punkten (15) vertikal und durchgehend ausgebildet ist.

9. Vorrichtung nach Anspruch 5, dadurch gekennzeichnet, dass die Verbindungsmittel nur eine Spaltenverbindung (c) für zwei Punktspalten (C) und nur eine bandförmige Lesediode (35) aufweisen, wobei die den Schirm bildenden Mittel je Spalte ein Gitter besitzen und die beiden einer und derselben Diode (35) beigeordneten Gitter auf phasenverschobene Potentiale ($\phi_G$, $\phi_D$) gebracht werden, um die an ein und dieselbe Spaltenverbindung (c) angeschlossenen Punkte nacheinander zu lesen, wobei die Spaltenverbindungen über eine der Weichenschaltvorrichtungen (67, 69) an die beiden Zeilenspeicher (27, 29) angeschlossen sind und diese Weichenschaltvorrichtungen nach Massgabe des Ausgangspunktes der Ladungen dieselben einem der Zeilenspeicher zuleiten.

10. Vorrichtung nach einem der vorstehenden Ansprüche, dadurch gekennzeichnet, dass die zweiten Ladungssammelzonen (38) jedes lichtempfindlichen Punktes (30, 50) an solchen Stellen des lichtempfindlichen Punktes liegen, die von dem Schirmgitter (34, 54, 64, 74) und dem MOS-Kondensatorgitter freigelassen werden.

11. Vorrichtungen nach einem der vorstehenden Ansprüche, dadurch gekenzeichnet, dass jede der zweiten Ladungssammelzonen (38) durch eine Diode gebildet ist.

12. Vorrichtung nach Anspruch 11, dadurch gekennzeichnet, das die Diode sich ferner unter das MOS-Kondensatorgitter (33) eines jeden lichtempfindlichen Punktes erstreckt.

13. Vorrichtung nach einem der vorstehenden Ansprüche, dadurch gekenzeichnet, dass die Isolierung (31, 51) durch eine verdickte Zone der die Halbleiterträgerschicht (21) bedeckenden Isolierschicht (22) gebildet ist.

14. Vorrichtung nach Anspruch 13, dadurch gekennzeichnet, dass die Isolierugn (31, 51) ferner eine unter der verdickten Zone der Isolierschicht angeordnete Superdotierung der Halbleiterträgerschicht (21) umfasst.

15. Vorrichtung nach einem der vorstehenden Ansprüche, dadurch gekennzeichnet, dass sie ferner ein für das Lichtbild undurchlässiges Band (32) aufweist, dessen Breite wenigstens derjenigen der Lesedioden (35) gleich ist und das für jede Spaltenverbindung oberhalb des Schirmgitters (34, 54, 64, 74) angeordnet ist.

16. Vorrichtung nach Anspruch 15, dadurch gekennzeichnet, dass das für das Lichtbild undurchlässige Band (32) aus Aluminium besteht.

17. Vorrichtung nach einem der vorstehenden Ansprüche, dadurch gekennzeichnet, dass die erste Farbe grün, die zweite Farbe blau und die dritte Farbe rot ist.

18. Vorrichtung nach einem der vorstehenden Ansprüche, dadurch gekennzeichnet, dass die Verschieberegister Ladungsübertragungsregister vom Typ CCD sind.

19. Fernsehkamera, dadurch gekennzeichnet, dass sie eine Bildanalysiervorrichtung nach einem der vorstehenden Ansprüche umfasst.

**Claims**

1. Device for the analysis of colour images, utilizing the transfer of electrical charges, comprising a photosensitive assembly formed of a plurality of elementary photosensitive zones, called dots (15), in which are created electrical charges in function of the lighting received, realized on a single semiconductor substrate (21) along N lines (L) and M columns (C) and insulated from one another, forming a matrix (1), each dot receiving a coloured filter (R, V, B) intended to only render sensitive one predefined colour, characterized in that:

— each of the elementary zones (15) comprises a MOS capacitor (33-21-22), constituting a first charge-collecting zone and comprises a grid (33) that is common to the capacitors of a single line, and a second charge-collecting zone (38), electrically connected to the capacitor;

— connection and control means ensure the supply in parallel through the intermediary of column connections of the electrical charges created in the M dots of a single line, successively for N lines, these means comprising a plurality of reading diodes (35), arranged in columns between the dots in such a way as to each receive successively, on order, the charges of at least two dots belonging to two different lines;

— means forming a screen for the charges are placed between each of the dots and the connection means, these screen means comprising a plurality of grids (34, 54, 64, 74) arranged in columns between the reading diodes and the dots and brought to a constant voltage ($V_E$, $\phi_G$, $\phi_D$), at least during the transfer of the charges of the dots towards the connection means;

— two memories (27, 29) called line memories, realized in the same semiconductor substrate (21), receive in parallel the electrical charges supplied by connection and control means, in such a way that each dot of the matrix is affected by only one of the two line memories, one of these memories (27) only being connected to dots of a single colour;

— two analogue shift registers (37, 39) receive in parallel respectively the charges supplied by the two line memories and each supply in series an electric analysis signal of the image.

2. Device according to Claim 1, characterized by the fact that the coloured filters (V, B, R) respectively placed on the photosensitive dots (15) render them sensitive respectively to a first, second and third colour, one of the line memories only being connected to dots of the first colour.

3. Device according to Claim 2, characterized by the fact that the dots (15) of a single line (L) are arranged according to the first — third — first —

second colour (V, R, V, B) sequence, the dots of the first colour (V) being placed in zigzag from one line to another, the dots of a single column (C) being connected alternately to the connections of the column (c) situated to the right and to the left of the column (C) of the dots involved, so that one of the line memories (27) is only connected to the dots of the first column (V), the other line memory being connected to both the dots of the other colours (B and R).

4. Device according to Claim 3, characterized by the fact that the means forming the screen comprise a grid (34), brought to a constant voltage ($V_E$), in the form of a strip per column, the reading diodes (35) also being in the form of a strip, of a width smaller than the preceding ones, formed in the semiconductor substrate (21) under each of the screen grids (34), the insulation (31) of the photosensitive dots with respect to the others being realized horizontally between the two grids of the MOS capacitor (33), continuously except at the level of the reading diodes (35), and vertically continuously, in steps crenellated about each of the photosensitive dots (30).

5. Device according to Claim 2, characterized by the fact that the dots (15) of a single line are alternately of the first and second colours, for two successive lines, then of the first and third colours for the two following lines, and so on, the dots of the first colour (V) being placed in zigzag from one line to another, the dots (15) of a single column (C) being connected together to the two line memories (27, 29) through the intermediary respectively of two launching devices (47, 49) ensuring assignment for the uneven lines of the uneven columns to one of the line memories and even columns to the other of the memories, the process being reversed for the even lines, so that one of the memories (27) only receives charges issuing from dots of the first colour (V) and the other memory (29) receives lines each one only comprising one of the other colours alternately.

6. Device according to Claim 2, characterized by the fact that the dots (15) of a single line are alternately of the first and second colours, for two successive lines, then of the first and third colours for the two following lines, and so on, the dots of the first colour (V) being placed in columns, the dots (15) of a single column (C) being connected together to one of the two line memories (27, 29), one of the memories (27) only receiving charges issuing from dots of the first colour (V) and the other memory (29) receiving lines comprising only one of the other colours, alternately.

7. Device according to Claim 3 or 5, characterized by the fact that the connections of column (c) are grouped two by two between the columns (C) of dots (15).

8. Device according to Claims 5 and 6, characterized by the fact that the means forming the screen comprise a grid (54) in the form of a strip per column, brought to constant voltage ($V_E$), the reading diodes (35) also being in the form of a strip of smaller width than the previous ones, formed in the semiconductor substrate (21) and joined two by two under each of the screen grids (54), the insulation of the photosensitive dots (50) with respect to one another being realized horizontally between two grids of MOS capacitor (33), in a continuous manner apart from at the level of the reading diodes (35) and vertically in a continuous manner between two adjacent reading diodes (35) and between two adjacent photosensitive dots (50).

9. Device according to Claim 5, characterized by the fact that the connection means only comprise a single connection of column (c) for two columns of dots (C) and a single reading diode (35) in the form of a strip, the means forming the screen comprising a grid per column, the two grids (64, 74) relative to a single diode (35) being subjected to voltages in phase opposition ($\phi_G$, $\phi_D$) in order to realize sequentially the reading of dots connected to a single connection of column (c), the column connections being connected to two line memories (27, 29) through the intermediary respectively of two (67, 69) ensuring for a single line switching of the charges towards one of the line memories in function of the dot from which they issue.

10. Device according to one of the preceding claims, characterized by the fact that the second charge-collecting zones (38) of each photosensitive dot (30, 50) are situated at the locations of the photosensitive dot left free by the screen grid (34, 54, 64, 74) and the grid of the MOS capacitor (33).

11. Device according to one of the preceding claims, characterized by the fact that each of the second charge-collecting zones (38) is constituted by a diode.

12. Device according to Claim 11, characterized by the fact that the diode extends furthermore under the grid of the MOS capacitor (33) of each of the photosensitive dots.

13. Device according to one of the preceding claims, characterized by the fact that the insulation (31, 51) is realized by an over-thickness of the insulating layer (22) covering the semiconductor substrate.

14. Device according to Claim 13, characterized by the fact that the insulation (31, 51) comprises, furthermore, an over-doping of the semiconductor substrate (21), realized under an over-thickness of the insulating layer.

15. Device according to one of the preceding claims, characterized by the fact that it comprises, furthermore, a strip (32) opaque to the luminous image, of a width at least equal to that of the reading diodes (35), deposited below the screen grid (34, 54, 64, 74), for each of the column connections.

16. Device according to Claim 15, characterized by the fact that the strip (32) opaque to the luminous image is realized in aluminium.

17. Device according to one of the preceding claims, characterized by the fact that the first, second and third colours are respectively green, blue and red.

18. Device according to one of the preceding claims, characterized by the fact that the shift registers are CCD type charge transfer registers.

19. Television camera, characterized in that it comprises an image analysis device according to one of the preceding claims.

*Remark of the translator: V, B, R being used in the specification and drawings and classically designating Green, Blue and Red (Vert, Bleu and Rouge in French), these initial letters have been kept in English. They thus correspond to G, B, R in English, as indicated in Claim 17. In the same manner subscripts D and G (Droite and Gauche in French) have been kept in the place of Right and Left.*

# FIG_1

# FiG_2

# FIG_3-a

# FIG_3-b

### coupe AA

0 063 061

FIG_4·a

FIG_4·b

# FIG_5-a

$C_i$  $C_{i+1}$

51

$L_{i-1}$

33

B    56    B

$L_i$

33

38   50

35   54   35   54

51

# FIG_5-b

## coupe BB

32

33    22

38   35   54   38   51   21

**FIG_ 6-a**

$\phi_H$
$\phi_D$

$C_1$ $C_2$ $C_3$ $C_4$ $C_5$ $C_6$ $C_7$ $C_8$

$L_1$ — B V B V B V B V

$L_2$ — V R V R V R V R

$L_3$ — R V R V R V R V

$L_4$ — V B V B V B V B

$L_5$ — B V B V B V B V

$L_6$ — V R V R V R V R

$\phi_G$
$\phi_B$

**FIG_ 6-b**

$$\phi_B \qquad t$$
$$\phi_H \qquad t$$
$$\phi_G \qquad t$$
$$\phi_D \qquad t$$

D

$t_8$ $t_9$ $t_{10}$ $t_{11}$

25

# FIG_7-a

# FIG_7-b

coupe CC